# EUROPEAN PATENT APPLICATION

(11) **EP 4 129 910 A1**
(43) Date of publication of application: **08.02.2023**
(21) Application number: 21779392.6
(22) Date of filing: 24.03.2021
(51) Int. Cl.: C01F 7/02, C01F 7/42, H01L 23/29, H01L 23/31, C08L 101/00, C08K 3/22, C08K 3/36

(54) **ALUMINA POWDER, FILLER COMPOSITION, RESIN COMPOSITION, ENCAPSULANT, AND FINGERPRINT AUTHENTICATION SENSOR**

(30) Priority: 31.03.2020 JP 2020063815
(71) Applicant: Denka Company Limited, Tokyo 103-8338 (JP)
(72) Inventor: NITTA, Junya, Tokyo 103-8338 (JP); YAMAGUCHI, Jun, Tokyo 103-8338 (JP); KAWABATA, Tomohiro, Tokyo 103-8338 (JP); HIRAI, Hideaki, Tokyo 103-8338 (JP); NISHI, Yasuhisa, Tokyo 103-8338 (JP)
(74) Representative: Zacco Sweden AB
(86) International application number: PCT/JP2021/012293
(87) International publication number: WO 2021/200485

(57) **Abstract**

The alumina powder of the present invention is an alumina powder containing alumina particles, wherein among the alumina particles, an average sphericity of an alumina particle having a projected area equivalent circle diameter of 50 nm or more as determined by microscopy is 0.80 or more, a content ratio of an alumina particle having a particle diameter of 75 µm or more is 0.05% by mass or less, an average particle diameter of the alumina powder is 0.2 µm or more and 15 µm or less, the average particle diameter is a particle diameter measured using a laser light diffraction scattering particle size distribution analyzer, and an amount of water included in the alumina powder measured by a specific measurement method is 30 ppm or more and 500 ppm or less.

## Description

### Technical Field

The present invention relates to an alumina powder, a filler composition, a resin composition, an encapsulant, and a fingerprint authentication sensor.

### Background Art

In recent years, the computerization and networking of information have greatly progressed, and the management of confidential information on a company and an individual has become important. In the access control to this confidential information, a personal authentication function is required, and a fingerprint authentication function is becoming widespread in a field where an advanced authentication function is required.

Examples of the type of fingerprint authentication include an optical type, a heat-sensitive type, and a capacitive type, and in a mobile terminal typified by a smartphone and a tablet, capacitive fingerprint authentication is often used from the viewpoint of high reliability, high resolution, and miniaturization. Capacitive fingerprint authentication needs to detect the difference in capacitance due to a subtle unevenness of a fingerprint with good precision, and in order to increase the capacitance of a fingerprint authentication system, an encapsulant for protecting a fingerprint authentication sensor is required to have a higher dielectric constant. A dielectric material such as an alumina powder is used in order to cause the encapsulant to have a higher dielectric constant (Patent Document 1 and the like).

The fingerprint authentication sensor is usually disposed on a semiconductor chip, and the semiconductor chip and the fingerprint authentication sensor are connected by a wire typified by a gold wire. Then, the fingerprint authentication sensor is encapsulated together with this wire by an encapsulant.

### Citation List

### Patent Document

Patent Document 1: Japanese Patent Laid-Open No. 2005-112665

### Summary of Invention

### Technical Problem

In a recent fingerprint authentication sensor, a wire typified by a gold wire has been becoming thinner from the viewpoint of miniaturization, and along with this, when the sensor is encapsulated by an encapsulant, the so-called wire sweep in which a wire is deformed by the flow pressure of the encapsulant and the collision of a filler with the wire is generated. Because of this, a problem is that the fraction defective of the fingerprint authentication sensor increases. On the other hand, if the viscosity of the encapsulant is lowered in order to improve the wire sweep, a phenomenon in which the encapsulant overflows out from an air vent section of a mold, the so-called burr, is generated. From the above, the state-of-the-art encapsulant including a dielectric material is required to have the property of being able to suppress wire sweep and the generation of a burr and carry out encapsulation.

The present invention has been made in view of such a problem, and an object thereof is to provide an alumina powder, and a filler composition, a resin composition, an encapsulant, and a fingerprint authentication sensor including the alumina powder, that can suppress wire sweep and the generation of a burr during encapsulation.

### Solution to Problem

The present inventors have carried out diligent and extensive research to achieve the above object, and as a result have found that by using a specific alumina powder including specific alumina particles, it is possible to obtain a filler composition, a resin composition, an encapsulant, and a fingerprint authentication sensor that can suppress wire sweep and the generation of a burr during encapsulation, and have completed the present invention.

That is, the present invention is as follows.
[1] An alumina powder containing alumina particles, wherein among the alumina particles, an average sphericity of an alumina particle having a projected area equivalent circle diameter of 50 nm or more as determined by microscopy is 0.80 or more, a content ratio of an alumina particle having a particle diameter of 75 µm or more is 0.05% by mass or less, an average particle diameter of the alumina powder is 0.2 µm or more and 15 µm or less, the average particle diameter is a particle diameter measured using a laser light diffraction scattering particle size distribution analyzer, and an amount of water included in the alumina powder measured by the following measurement method is 30 ppm or more and 500 ppm or less:
   (Measurement method)
   1 g of the alumina powder is heated to raise a temperature thereof from normal temperature to 900°C, and an amount of water generated at 500°C or more and 900°C or less is measured by the Karl Fischer coulometric titration method.
[2] The alumina powder according to [1], wherein a content ratio of an alumina particle having a particle diameter of 25 µm or more and less than 75 µm is 0.1% by mass or less.
[3] The alumina powder according to [1] or [2], wherein a content ratio of an alumina particle having a particle diameter of 1 µm or less is 1% by mass or more and 35% by mass or less, and an average sphericity of an alumina particle having a projected area equivalent circle diameter of 50 nm or more and 1 µm or less as determined by microscopy is 0.80 or more.
[4] A filler composition containing the alumina powder according to any one of [1] to [3] and a silica.
[5] A resin composition containing a resin and the alumina powder according to any one of [1] to [3] or the filler composition according to [4].
[6] An encapsulant containing the resin composition according to [5].
[7] A fingerprint authentication sensor containing the encapsulant according to [6].

### Advantageous Effect of Invention

According to the present invention, an alumina powder, and a filler composition, a resin composition, an encapsulant, and a fingerprint authentication sensor including the alumina powder, that can suppress wire sweep and the generation of a burr during encapsulation can be provided.

### Description of Embodiment

Hereinafter, an embodiment for practicing the present invention (hereinafter, simply referred to as "the present embodiment") will be described in detail. The following present embodiment is an illustration for describing the present invention, and the present invention is not limited only to the present embodiment.

The alumina powder of the present embodiment includes specific alumina particles. Hereinafter, unless otherwise specified, the alumina particle according to the present embodiment is also simply referred to as the "alumina particle," and the alumina powder including the alumina particle according to the present embodiment is also simply referred to as the "alumina powder."

### [Alumina powder]

Among the alumina particles, the average sphericity of an alumina particle having a projected area equivalent circle diameter of 50 nm or more by the following microscopy is 0.80 or more, and preferably 0.86 or more and 0.98 or less. When the average sphericity of the alumina particle is in the above range, thickening is less likely to occur when a resin is filled with the alumina powder, the viscosity of an encapsulant is in a suitable range, and deformation of a wire due to the flow pressure of the encapsulant can be suppressed during encapsulation. In addition, when the average sphericity thereof is in the above range, overflowing out of the encapsulant from an air vent section of a mold can also be suppressed. In the present embodiment, the sphericity and the average sphericity are measured, for example, by the following microscopy. That is, a particle image (photograph, magnification: 2000 times) taken using a scanning electron microscope, a transmission electron microscope, or the like is taken into an image analyzer, and the projected area (SA) and the perimeter (PM) of the particle are measured from the particle image. When the area of a perfect circle having the same perimeter as the perimeter (PM) is (SB), the sphericity of the particle is SA/SB. Therefore, when envisioning a perfect circle having the same perimeter as the perimeter (PM) of a sample, PM = 2πr and SB = πr², and thus SB = π × (PM/2π)², and the sphericity of each particle is sphericity = SA/SB = SA × 4π/(PM)². The sphericities of 200 arbitrary particles having a projected area equivalent circle diameter of 50 nm or more are determined as described above, and the arithmetic mean value of the sphericities of the individual particles was taken as the average sphericity. The upper limit of the projected area equivalent circle diameter is usually 50 µm. A specific measurement method is as described in Examples. In addition, the projected area equivalent circle diameter refers to the diameter of a perfect circle having the same projected area as the projected area (SA) of a particle.

Among the alumina particles, the content ratio of an alumina particle having a particle diameter of 75 µm or more is 0.05% by mass or less, and preferably 0.02% by mass or less. If the particle diameter of an alumina particle is 75 µm or more, when the alumina particle collides with a wire, the wire is easily deformed, but by reducing the content ratio of such an alumina particle to 0.05% by mass or less, the frequency of collision of the alumina particle with the wire can be reduced, and thus wire sweep can be suppressed. In addition, when the content ratio of such an alumina particle is 0.05% by mass or less, the surface smoothness of a fingerprint authentication sensor obtained is easily kept, and the sensitivity is improved. The lower limit of the content ratio is, for example, 0% by mass. In the present embodiment, the particle diameter is measured using a laser light diffraction scattering particle size distribution analyzer. A specific measurement method is as described in the Examples.

The average particle diameter of the alumina powder is 0.2 µm or more and 15 µm or less. When the average particle diameter is in the above range, thickening is less likely to occur when a resin is filled with the alumina powder, the viscosity of an encapsulant is in a suitable range, and deformation of a wire due to the flow pressure of the encapsulant can be suppressed during encapsulation. In addition, when the average particle diameter is in the above range, overflowing out of the encapsulant from an air vent section of a mold can also be suppressed. Further, when the average particle diameter is in the above range, the effect of being able to keep the surface smoothness of a fingerprint authentication sensor obtained is also exhibited. When the average particle diameter is 0.2 µm or more, it is possible to suppress an increase in the viscosity of the encapsulant due to the presence of a fine particle when a resin is filled with the alumina powder and to reduce wire sweep. When the average particle diameter is 15 µm or less, a burr of the encapsulant can be reduced when the resin is filled. In the present embodiment, the average particle diameter is measured using a laser light diffraction scattering particle size distribution analyzer. A specific measurement method is as described in the Examples.

The amount of water included in the alumina powder measured by the following measurement method is 30 ppm or more and 500 ppm or less, and preferably 50 ppm or more and 450 ppm or less.

### (Measurement method)

1 g of the alumina powder is heated to raise the temperature thereof from normal temperature to 900°C, and the amount of water generated at 500°C or more and 900°C or less is measured by the Karl Fischer coulometric titration method. A specific measurement method is as described in the Examples.

When the amount of water is in the above range, thickening is less likely to occur when a resin is filled with the alumina powder, the viscosity of an encapsulant is in a suitable range, and deformation of a wire due to the flow pressure of the encapsulant can be suppressed during encapsulation. In addition, when the amount of water is in the above range, overflowing out of the encapsulant from an air vent section of a mold can also be suppressed. Further, when the amount of water is in the above range, the effect of being able to keep the surface smoothness of a fingerprint authentication sensor obtained is also exhibited.

The reason for this is not clear, but the present inventors presume as follows. However, the reason is not limited to the following.

It is presumed that the water generated at 500°C or more and 900°C or less is mainly derived from a hydroxyl group on the surface of the alumina powder, and thus it is presumed that the alumina powder has a small amount of a hydroxyl group. The resin is usually hydrophobic, and thus if a large number of hydroxyl groups are present on the surface of the alumina powder, the affinity between the resin and the alumina powder is low, and it becomes difficult to control the flow pressure of the encapsulant. In addition, the alumina powder is difficult to hold in the resin, and thus the frequency of collision of the alumina particle with the wire increases. Further, the resin easily protrudes from the alumina powder, and thus it becomes difficult to keep the surface smoothness of a fingerprint authentication sensor having an encapsulant. On the other hand, if the number of hydroxyl groups on the surface of the alumina powder is small, the affinity for the resin is good, but the viscosity is high, and thus the encapsulant overflowing out from an air vent section of a mold, the generation of the so-called burr, easily occurs. It is presumed that in the present embodiment, as a result of the amount of water derived from a hydroxyl group on the alumina surface being in the above range, the affinity for the resin can be appropriately held, and thus wire deformation and the generation of a burr are suppressed and the effect of being able to keep the surface smoothness of a fingerprint authentication sensor obtained is also exhibited.

Among the alumina particles, the content ratio of an alumina particle having a particle diameter of 25 µm or more and less than 75 µm is preferably 0.1% by mass or less. The lower limit of the content ratio thereof is, for example, 0% by mass or more. A specific measurement method is as described in the Examples.

When the content ratio thereof is in the above range, thickening is less likely to occur when a resin is filled with the alumina powder, the viscosity of an encapsulant is in a suitable range, and deformation of a wire due to the flow pressure of the encapsulant tends to be able to be further suppressed during encapsulation. In addition, when the content ratio thereof is in the above range, the effect of being able to keep the surface smoothness of a fingerprint authentication sensor obtained better is also exhibited. If the particle diameter of an alumina particle is 25 µm or more, when the alumina particle collides with a wire, the wire is easily deformed, but by reducing the content ratio of such an alumina particle to 0.1% by mass or less, the frequency of collision of the alumina particle with the wire can be reduced, and thus wire sweep tends to be able to be suppressed. In addition, when the content ratio of such an alumina particle is 0.1% by mass or less, the surface smoothness of a fingerprint authentication sensor obtained is easily kept, and the sensitivity tends to be improved.

Among the alumina particles, the content ratio of an alumina particle having a particle diameter of 1 µm or less is preferably 1% by mass or more and 35% by mass or less. When the content ratio thereof is in the above range, thickening is less likely to occur when a resin is filled with the alumina powder, the viscosity of an encapsulant is in a suitable range, and deformation of a wire due to the flow pressure of the encapsulant tends to be able to be further suppressed during encapsulation.

In addition, when the content ratio thereof is in the above range, overflowing out of the encapsulant from an air vent section of a mold also tends to be able to be further suppressed. When the content ratio of the alumina particle having a particle diameter of 1 µm or less is 35% by mass or less, the increase in viscosity due to a coarse particle can be further suppressed, and the flow pressure of the encapsulant can be further easily controlled. On the other hand, when the content ratio thereof is 1% by mass or more, it is easier to form a propagation path by a fine particle, and a high dielectric having a higher dielectricity tends to be easily obtained. A specific measurement method is as described in the Examples.

Among the alumina particles, the average sphericity of an alumina particle having a projected area equivalent circle diameter of 50 nm or more and 1 µm or less as determined by the above microscopy is preferably 0.80 or more, and more preferably 0.80 or more and 0.98 or less. When the average sphericity thereof is in the above range, thickening is less likely to occur when a resin is filled with the alumina powder, the viscosity of an encapsulant is in a suitable range, and deformation of a wire due to the flow pressure of the encapsulant can be further effectively suppressed during encapsulation. In addition, when the average sphericity thereof is in the above range, overflowing out of the encapsulant from an air vent section of a mold can also be more effectively suppressed.

The specific surface area of the alumina powder is preferably 1.0 m²/g or more and 15 m²/g or less, and more preferably 1.5 m²/g or more and 10 m²/g or less, from the viewpoint of maintaining good fluidity of the encapsulant. In the present embodiment, the measurement of the specific surface area is a value based on the BET method, and is measured, for example, by the following method. That is, specific surface area measuring instrument "Macsorb HM model-1208 (trade name)" manufactured by Mountech Co., Ltd. is used and 1.0 g of the alumina particle is used to carry out measurement by the BET onepoint method. Prior to the measurement, the alumina particle is heated at 300°C for 5 minutes in a nitrogen gas atmosphere as a pretreatment. In addition, in the BET measurement, a mixed gas of 30% nitrogen and 70% helium is used as an adsorption gas, and the flow rate is adjusted such that the indicated value of the main body flowmeter is 25 ml/min.

### [Method for producing alumina powder]

Examples of a raw material used for obtaining the alumina powder include a metal aluminum powder, an aluminum hydroxide powder or a slurry thereof, and an alumina powder or a slurry thereof, and among these, a metal aluminum powder and an alumina powder are preferable. It is preferable to appropriately use a metal aluminum powder and/or a metal aluminum powder having an average particle diameter in the range of 1 µm or more and 20 µm or less as the raw material. In addition, the alumina powder may be an alumina powder obtained by melting, cooling, and pulverizing alumina to prepare a pulverized fused alumina product and then subjecting the pulverized product to classification treatment. The metallic aluminum powder and the alumina powder may be commercially available products.

In order to spheroidize the metallic aluminum powder and the alumina powder, a flame melting method is usually used. An advantage of this method is that spheroidization is easy.

The metallic aluminum powder and the alumina powder are sprayed and supplied into a flame by a dry feed method involving dispersing the metallic aluminum powder and the alumina powder, respectively, in a gas such as oxygen and air. As a spraying method, a spray nozzle as used in a spray dryer can be utilized, it is important to sufficiently disperse the powder by a feed method having a strong dispersion function, and for example, it is preferable to do so by a ring nozzle method that utilizes dispersion by a shear force due to a high-speed air flow using a feed tube section in the shape of an ejector nozzle.

In order to form a flame, a fuel gas such as hydrogen, natural gas, acetylene gas, propane gas (LP gas), and butane and a supporting gas such as air and oxygen may be injected from a nozzle and burned. In addition, the flame melting is carried out while constantly supplying water such as ion exchanged water and changing the water vapor concentration in the atmosphere in order to adjust the amount of water in the alumina powder obtained as determined by the Karl Fischer coulometric titration method. For water spraying, for example, a spray nozzle can be utilized, and pressurized air is usually used as a dispersion gas for the nozzle. The temperature of the water to be sprayed is usually preferably controlled to about room temperature (25°C). The flame temperature is preferably held at 2050°C or more and 2300°C or less. If the flame temperature is higher than 2300°C, it becomes difficult to obtain the quenching effect, and if the flame temperature is lower than 2050°C, it becomes difficult to realize a high sphericity. The flame temperature can be controlled, for example, by changing the amount of the fuel gas supplied. In addition, by appropriately changing the amount of the fuel gas supplied in the range of 3 Nm³/hour or more and 15 Nm³/hour or less, the amount of the supporting gas suppled in the range of 15 Nm³/hour or more and 75 Nm³/hour or less, and the amount of water supplied in the range of 30 L/hour or more and 90 L/hour or less individually, alumina powders different in average sphericity, average particle diameter, and the amount of water included therein can be prepared.

The metal aluminum powder and the alumina powder injected into the flame undergoes high temperature heat treatment and thereby the alumina powder is spheroidized.

The heat-treated powder is sucked together with the exhaust gas by a blower or the like, and is collected by a collector of a cyclone or a bag filter. The collection temperature at this time is preferably 500°C or more. Because of the material of the collector, the upper limit of the collection temperature is preferably about 1100°C. In addition, by setting the collection temperature to 500°C or more, it is possible to suppress the mixing of another cation impurity or anion impurity in a large amount and to make the neutrality of the alumina powder more sufficient.

In addition, the alumina powder obtained is preferably subjected to classification treatment using, for example, a JIS standard stainless steel test sieve to adjust each of the content ratio of the alumina particle having a particle diameter of 75 µm or more and the content ratio of the alumina particle having a particle diameter of 25 µm or more and less than 75 µm.

### [Filler composition and method for producing the same]

The filler composition according to the present embodiment (hereinafter, also simply referred to as the "filler composition") includes the alumina powder according to the present embodiment and a silica. By including the alumina powder and a silica, the filler composition according to the present embodiment has improved fluidity and can suitably suppress deformation of a wire due to the flow pressure of an encapsulant.

### (Silica)

As the silica, for example, a known silica such as crystalline silica, amorphous silica, quartz, fumed silica, and silicic anhydride can be used. Among these, amorphous silica is preferable from the viewpoint of the insulating property and the moisture resistance stability in the case of use as an encapsulant.

For the silica, the average sphericity of a silica having a projected area equivalent circle diameter of 0.05 µm or more as determined by the above microscopy is preferably 0.85 or more. If the average sphericity of the silica is in the above range, when a resin is filled with the silica together with the alumina powder, it is possible to reduce the frictional resistance when the silica enters a gap of the alumina powder. As a result, a resin filled with these particles is less likely to thicken, the viscosity of an encapsulant is in a suitable range, and deformation of a wire due to the flow pressure of the encapsulant can be suppressed during encapsulation. In addition, overflowing out of the encapsulant from an air vent section of a mold can also be suppressed.

As the silica, it is preferable to use a silica having an average particle diameter of 0.05 µm or more and 1.5 µm or less. When such a silica is used, the silica can efficiently enter a gap of the alumina powder, and in the case of use as an encapsulant, the amount of wire sweep can be further reduced and the burr reducing effect can be further enhanced.

The silica may be surface-treated using a known surface treatment.

### (Method for producing silica)

Examples of a method for producing a silica include (1) a method involving placing a metal silane particle in a high temperature field formed by a chemical flame, an electric furnace, or the like and carrying out spheroidization while causing an oxidation reaction, (2) a method involving spraying a slurry of a metal silane particle into a flame and carrying out spheroidization while causing an oxidation reaction, (3) a method for producing a silica involving using an alkali metal silicate such as sodium silicate called a colloidal silica as a raw material and removing a metal ion by neutralization or ion exchange, and (4) a method for producing a silica involving using an alkoxysilane such as tetraethoxysilane as a raw material and carrying out hydrolysis and condensation in an organic solvent.

### (Content ratio of each of alumina powder and silica)

When the filler composition includes an alumina powder and a silica, the filler composition includes the alumina powder in an amount of preferably 85% by volume or more and 99.8% by volume or less, and more preferably 90% by volume or more and 98% by volume or less, per 100% by volume of the filler composition from the following viewpoints: the filler composition can suitably suppress wire sweep and the generation of a burr during encapsulation, has further improved fluidity, and can more suitably suppress deformation of a wire due to the flow pressure of an encapsulant. In addition, the silica is included in an amount of preferably 0.02% by volume or more and 15% by volume or less, and more preferably 2% by volume or more and 10% by volume or less, per 100% by volume of the filler composition.

### (Method for producing filler composition)

As the filler composition of the present embodiment, one alumina powder according to the present embodiment may be used as it is. In addition, the filler composition according to the present embodiment may be obtained by appropriately mixing two or more alumina powders. Further, the filler composition according to the present embodiment may be obtained by appropriately mixing the alumina powder according to the present embodiment and a silica. Examples of a mixing method include ball mill mixing.

### [Resin composition and method for producing the same]

The resin composition according to the present embodiment includes a resin, and the alumina powder or the filler composition according to the present embodiment. By including the alumina powder, the resin composition according to the present embodiment can suitably suppress wire sweep and the generation of a burr during encapsulation. In addition, by including the filler composition, the resin composition according to the present embodiment has further improved fluidity and can more suitably suppress deformation of a wire due to the flow pressure of an encapsulant, in addition to the effect of including the alumina powder.

### (Resin)

As the resin, for example, an epoxy resin, a silicone resin, a phenol resin, a melamine resin, a urea resin, an unsaturated polyester, or a fluororesin can be used. One of these resins can be used alone or two or more thereof can be appropriately mixed and used.

### (Content ratio of each of alumina powder, filler composition, and resin)

In the resin composition of the present embodiment, the content ratio of the alumina powder according to the present embodiment is preferably 10% by mass or more and 95% by mass or less, and more preferably 30% by mass or more and 93% by mass or less, per 100% by mass of the resin composition. In addition, when the filler composition is included in the resin composition, the total content ratio of a filler component included in the filler composition according to the present embodiment is preferably 10% by mass or more and 95% by mass or less, and more preferably 30% by mass or more and 93% by mass or less, per 100% by mass of the resin composition. In these cases, the content ratio of the resin (solids) is preferably 5% by mass or more and 90% by mass or less, and more preferably 7% by mass or more and 70% by mass or less, from the viewpoint of moldability of the resin composition.

### (Other components)

In addition to the alumina powder and the resin according to the present embodiment, the resin composition of the present embodiment may include, as necessary, an inorganic filler, a stress reducing agent, a rubber-like substance, a reaction retarder, a curing agent, a curing accelerator, a flame retardant aid, a flame retardant, a colorant, a tackifier, a UV absorber, an antioxidant, a fluorescent whitener, a light sensitizer, a thickener, a lubricant, a antifoamer, a surface conditioner, a brightener, a silane coupling agent, a release agent, a polymerization inhibitor, or like, as long as a characteristic of the present embodiment is not impaired. One of these components can be used alone or two or more thereof can be appropriately mixed and used. In the resin composition of the present embodiment, the total content ratio of the other components may be usually 10% by mass or less, 5% by mass or less, 3% by mass or less, 1% by mass or less, or 0.5% by mass or less per 100% by mass of the resin composition.

### (Method for producing resin composition)

Examples of a method for producing the resin composition of the present embodiment include a method involving sufficiently stirring a resin, the alumina powder or the filler composition, and, as necessary, another component to obtain the resin composition. The resin composition of the present embodiment can be produced, for example, by blending a predetermined amount of each component using a blender, a Henschel mixer, or the like, then kneading the resulting blend using a heating roll, a kneader, a single screw or twin screw extruder, or the like, cooling the kneaded product, and then pulverizing the same.

### [Encapsulant]

The encapsulant according to the present embodiment can suppress wire sweep and the generation of a burr during encapsulation, and thus can be suitably used as an encapsulant for protecting a capacitive fingerprint authentication sensor. The encapsulant can be produced, for example, by mixing the resin composition of the present embodiment with various known additives, solvents, or the like generally used for an encapsulant material application using a known mixer. As a method for adding various components or solvents at the time of the mixing, a generally known method can be appropriately adopted.

### [Fingerprint authentication sensor]

The fingerprint authentication sensor according to the present embodiment is a capacitive type, and is not particularly limited as long as it includes the encapsulant of the present embodiment. The fingerprint authentication sensor according to the present embodiment has a low fraction defective due to wire sweep, the generation of a burr, or the like, and can be massproduced at low cost. As a method for encapsulating the fingerprint authentication sensor using the encapsulant according to the present embodiment, for example, a known method such as a transfer molding method or a vacuum printing molding method can be applied.

### Examples

Examples and Comparative Examples are shown below, and the present invention will be described in detail, but the present invention is not limited to these Examples at all.

### [Evaluation methods]

### (1) Average sphericity of alumina particle

As described in the above microscopy, particle images of 200 arbitrary particles taken using a scanning electron microscope ("Model JSM-6301F" (trade name) manufactured by JEOL Ltd.) were taken into an image analyzer ("MacView" (trade name) manufactured by Mountech Co., Ltd.), and the projected area (SA) and the perimeter (PM) of each of the alumina particles included in the alumina powders obtained in the Examples and the Comparative Examples were measured from the photographs (magnification: 2000 times). These values were used to determine the sphericities of the individual particles of alumina particles having a diameter of 50 nm or more and alumina particles having a diameter of 50 nm or more and 1 µm or less. In addition, the arithmetic mean value of the sphericities of the individual particles was taken as the average sphericity.

### (2) Content ratio of each of alumina particles having a particle diameter of 75 µm or more and alumina particles having a particle diameter of 25 µm or more and less than 75 µm

The content ratio of each of the alumina particles having a particle diameter of 75 µm or more and the alumina particles having a particle diameter of 25 µm or more and less than 75 µm was measured by the following wet sieving method. A JIS standard stainless steel test sieve having an opening of 75 µm or 25 µm was set in sieving shaker "Octagon Digital (wet sieving unit) (trade name)" manufactured by Seishin Enterprise Co., Ltd., 10 g of each of the alumina powders obtained in the Examples and the Comparative Examples was precisely weighed, placed on the sieve, and shaken at a shower water volume of 9.5 L/min for 5 minutes, then the powder remaining on the sieve was transferred to an aluminum container and dried in the air at 120°C for 60 minutes, and the mass of the alumina powder on the sieve was weighed. The mass of the alumina powder on the sieve was divided by the mass of the alumina powder used for the measurement to obtain a percentage, and the proportion of the alumina powder remaining on the sieve was calculated to calculate the content ratio (% by mass) of each of the alumina particles having a particle diameter of 75 µm or more and the alumina particles having a particle diameter of 25 µm or more and less than 75 µm.

### (3) Content ratio of alumina particles having a particle diameter of 1 µm or less

The alumina particles having a particle diameter of 1 µm or less were separated from the alumina powders obtained in the Examples and the Comparative Examples by using a product on the sieve using a JIS standard stainless steel test sieve having an opening of 1 µm. After that, the mass of the alumina powder on the sieve was weighed. The mass of the alumina powder on the sieve was divided by the mass of the alumina powder used for the measurement to obtain a percentage, and the proportion of the alumina powder remaining on the sieve was calculated to calculate the content ratio (% by mass) of each of the alumina particles having a particle diameter of 1 µm or less.

### (4) Average particle diameter of alumina powder

The average particle diameter of the alumina powder was measured using laser light diffraction scattering particle size distribution analyzer LS-230 (trade name) manufactured by Beckman Coulter, Inc. At the time of measurement, 0.04 g of each of the alumina powders obtained in the Examples and the Comparative Examples to be measured was added to a mixed liquid of 0.5 mL of ethanol and 5 mL of ion exchanged water as a solvent, and the resulting mixture was subjected to a pretreatment for 2 minutes and dispersion treatment for 30 seconds using Ultrasonic Disruptor UD-200 (equipped with Special Micro Chip TP-030) (trade name) manufactured by TOMY SEIKO Co., Ltd. to obtain a slurry. Using this slurry, the particle size distribution was measured at a pump rotation speed of 60 rpm. In the analysis of the particle size distribution, 1.333 and 1.768 were used as the refractive indexes of water and the alumina particle, respectively. The analysis of the particle size distribution was carried out in parts by volume - cumulative. In the measured mass-based particle size distribution, the particle at a cumulative mass of 50% was taken as the average particle diameter (µm), and taken as the average particle diameter of the alumina powder.

### (5) Amount of water included in alumina powder

1 g of the alumina powder was placed in a moisture vaporizer (VA-122 (trade name) manufactured by Mitsubishi Chemical Analytech Co., Ltd.) and heated to raise the temperature thereof from normal temperature (25°C) to 900°C using an electric heater, and the amount of water generated at 500°C or more and 900°C or less that was the amount of water (ppm) included in the alumina powder was measured by the Karl Fischer coulometric titration method.

### (6) Dielectricity (relative permittivity), fluidity (spiral flow), moldability (burr length), amount of wire sweep, and preparation of encapsulant

Properties of each of the alumina powders obtained in the Examples and the Comparative Examples as an encapsulant were evaluated. Specifically, when an alumina powder having an average particle diameter of less than 1 µm was used, each component was blended according to formulation 1 in Table 1, and when the other alumina powders were used, each component was blended according to formulation 2 in Table 1, and the components were dry-blended at 1000 rpm for 1 minute using a Henschel mixer (Model FM-10B (trade name) manufactured by Mitsui Miike Chemical Machinery, Co., Ltd.). A biphenyl type epoxy resin (YX-4000H (trade name) manufactured by Japan Epoxy Resin Co., Ltd.) was used as an epoxy resin, a phenol aralkyl resin (MILEX (R) XLC-4L (trade name) manufactured by Mitsui Chemicals, Inc.) was used as a phenol resin, an epoxy-based silane compound (KBM-403 (trade name) manufactured by Shin-Etsu Chemical Co., Ltd.) was used as a silane coupling agent, triphenylphosphine (manufactured by Hokko Chemical Industry Co., Ltd.) was used as a curing accelerator, and carnauba wax (manufactured by Clariant) was used as a release agent. After that, the blend was heated and kneaded using a co-rotating intermeshing twin screw extrusion kneader (screw diameter D = 25 mm, L/D = 10.2, paddle rotation speed of 50 rpm or more and 120 rpm or less, discharge rate of 3.0 kg/hour, and kneaded product temperature of 94°C or more and 96°C or less). The kneaded product (discharged product) was pressed using a press, cooled, and then pulverized to produce an encapsulant. Using the obtained encapsulant, the dielectricity (relative permittivity), the fluidity (spiral flow), and the moldability (burr length) were evaluated according to the following methods.

**[Table 1]**

| Components | Formulation 1 | Formulation 2 |
|---|---|---|
| Alumina powder having average particle diameter of less than 1 µm (kg) | 1.7 | |
| Alumina powder having average particle diameter of 1 µm or more (kg) | | 1.2 |
| Epoxy resin (g) | 143 | 375 |
| Phenol resin (g) | 123 | 349 |
| Silane coupling agent (g) | 6 | 4 |
| Curing accelerator (g) | 4 | 10 |
| Release agent (g) | 16 | 15 |

### · Dielectricity (relative permittivity)

Using a transfer molding machine, each of the encapsulants obtained above was molded into a circular shape having a diameter of 100 mm and a thickness of 3 mm, and then post-cured to prepare a cured body of the encapsulant. The transfer molding conditions were a mold temperature of 175°C, a molding pressure of 7.5 MPa, and a holding time of 90 seconds, and the post-cure conditions were a heating temperature of 175°C and a heating time of 8 hours. A conductive paste (DOTITE (R) D-550 (trade name) manufactured by Fujikura Kasei Co., Ltd.) was thinly applied to the surface of the cured body of the encapsulant, and the relative permittivity was calculated from the capacitance measured at a temperature of 20°C, a humidity of 40%, and a frequency of 1 MHz using an LCR meter (HP4284A (trade name) manufactured by Agilent Technologies, Inc.) and an electrode for measurement (SE-70 (trade name) manufactured by Ando Electric Co., Ltd.). A larger value of the relative permittivity indicates better dielectricity. The value of the relative permittivity is preferably 6 or more from the viewpoint of improving the reading precision in the case of use as an encapsulant for a fingerprint authentication sensor.

### · Fluidity (spiral flow)

Using a transfer molding machine equipped with a mold for spiral flow measurement according to EMMI-I-66 (Epoxy Molding Material Institute; Society of Plastic Industry), the spiral flow value (cm) of each of the encapsulants obtained above was measured. The transfer molding conditions were a mold temperature of 175°C, a molding pressure of 7.5 MPa, and a holding time of 120 seconds. A larger value of the spiral flow indicates better fluidity.

### · Moldability (burr length)

Each of the encapsulants obtained above was inserted into a mold for burr measurement having slits of 2 µm and 5 µm, and molded at a molding temperature of 175°C and a molding pressure of 7.5 MPa. At that time, the encapsulant flowing out of the slits was measured using calipers, and the burr length (mm) for each slit width was measured. The average value of the burr length was calculated using the burr length for each slit width. A shorter average value of the burr length indicates better moldability.

### · Amount of wire sweep

An evaluation chip having a size of 8 mm in length, 8 mm in width, and 0.3 mm in height was placed on a substrate for FC-BGA (Flip Chip Ball Grid Array) via a dicing die attach film, and 8 places were connected using a gold wire to obtain a structure. The diameter of the gold wire was 20 µmϕ, the distance (pitch) between the centers of the gold wires was 80 µm, and the distance between the gold wires was 60 µm. After that, the structure was placed in the mold of the transfer molding machine, and each of the encapsulants obtained above was injected using a plunger such that the structure was encapsulated in the mold, molded into a package having a size of 38 mm in length, 38 mm in width, and 1.0 mm in height, and then post-cured to obtain a simulated chip encapsulant. Such 20 simulated chip encapsulants were prepared for each of the encapsulants obtained in the Examples and the Comparative Examples. The transfer molding conditions were a mold temperature of 175°C, a molding pressure of 7.5 MPa, and a holding time of 90 seconds, and the post-cure conditions were a heating temperature of 175°C and a heating condition of 8 hours. For the obtained simulated chip encapsulants, each gold wire portion was observed using a soft X-ray transmission apparatus to measure the maximum sweep distance which the gold wire was swept by packaging. This maximum sweep distance measurement was carried out for all of the 20 simulated chip encapsulants, an average value was calculated from the obtained maximum sweep distance of the gold wire for each thereof, and this average value was taken as the amount (µm) of wire sweep. A smaller value of the amount of wire sweep indicates a higher viscosity.

### [Example 1]

First, Alumina LS-21 (trade name) manufactured by Nippon Light Metal Co., Ltd. as a raw material used for producing an alumina powder was melted, cooled, and pulverized to prepare a pulverized fused alumina product. The pulverization treatment was carried out using a ball mill, and an alumina ball was used as a pulverization medium.

Alumina raw material 1 (average particle diameter: 3 µm), alumina raw material 2 (average particle diameter: 5 µm), alumina raw material 3 (average particle diameter: 8 µm), and alumina raw material 4 (average particle diameter: 14 µm) were prepared from the obtained pulverized alumina product by classification treatment.

Subsequently, the obtained alumina raw material 3 was entrained in oxygen gas (gas flow rate: 35 Nm³/hour) and supplied into a flame from a spray nozzle, and was subjected to flame melting treatment while constantly supplying a fuel gas (LP gas, gas flow rate: 7 Nm³/hour), and ion exchanged water (water supply rate: 90 L/hour) for adjusting the amount of water in the alumina powder obtained as determined by the Karl Fischer coulometric titration method into a production furnace. The alumina powder obtained by this treatment was conveyed to a bag filter by a blower together with the exhaust gas, and the alumina powder was collected. The supply of ion exchanged water into the production furnace was carried out by spraying using ATOMAX Nozzle Model BN160 manufactured by ATOMAX Co., Ltd. For the spraying, air pressurized to 0.5 MP using a compressor was used as a dispersion gas for the nozzle, and the temperature of water to be sprayed was controlled to 25°C. The nozzles for water spraying were inserted in two stages every 15° from the center of the furnace, and the nozzle position of the first stage was set at a height of 80 cm from the top of the furnace, and the position of the second stage was set at a height of 100 cm from the top of the furnace.

In the obtained alumina powder, in order to adjust the content ratio of alumina particles having a particle diameter of 75 µm or more and the content ratio of alumina particles having a particle diameter of 25 µm or more and less than 75 µm, classification was carried out using a JIS standard stainless steel test sieve having an opening of 75 µm or 25 µm.

The physical properties of the alumina powder after classification were evaluated, and results thereof are shown in Table 2. The relative permittivity was 6 or more.

### [Examples 2 to 10 and Comparative Examples 1 to 6]

Alumina powders were obtained in the same manner as in Example 1 except that the type of the alumina raw material, the supply rate of oxygen gas, the supply rate of the fuel gas, and the supply rate of ion exchanged water were changed according to Tables 2 and 3. In Examples 3 and 6 and Comparative Example 3, a metal aluminum powder (average particle diameter: 10 µm) was used as the alumina raw material.

The physical properties of each of the obtained alumina powders were evaluated, and results thereof are shown in Table 2 and 3. The relative permittivity was 6 or more except for Comparative Example 6, and was less than 6 in Comparative Example 6.

**[Table 2]**

| | Example 1 | Example 2 | Example 3 | Example 4 | Example 5 | Example 6 | Example 7 | Example 8 | Example 9 | Example 10 |
|---|---|---|---|---|---|---|---|---|---|---|
| Production conditions | | | | | | | | | | |
| Type of alumina raw material | 3 | 4 | Metal Al | 4 | 4 | Metal Al | 4 | 1 | 4 | 3 |
| Oxygen gas supply rate (Nm³/hour) | 35 | 50 | 15 | 60 | 75 | 15 | 60 | 50 | 60 | 35 |
| Fuel gas supply rate (Nm³/hour) | 7 | 10 | 3 | 12 | 15 | 3 | 12 | 10 | 12 | 7 |
| Ion exchanged water supply rate (L/hour) | 90 | 80 | 50 | 40 | 30 | 60 | 70 | 80 | 50 | 50 |

| Evaluations | | | | | | | | | | |
|---|---|---|---|---|---|---|---|---|---|---|
| Average sphericity of alumina particles having 50 nm or more | 0.80 | 0.92 | 0.93 | 0.94 | 0.96 | 0.93 | 0.91 | 0.92 | 0.93 | 0.81 |
| Content ratio of alumina particles having particle diameter of 75 µm or more (% by mass) | 0.01 | 0.05 | <0.01 | 0.02 | 0.01 | 0.01 | 0.02 | <0.01 | 0.01 | 0.02 |
| Average particle diameter of alumina powder (µm) | 8 | 14 | 0.2 | 15 | 14 | 0.3 | 12 | 3 | 13 | 9 |
| Amount of water included in alumina powder (ppm) | 230 | 110 | 480 | 50 | 30 | 500 | 90 | 280 | 60 | 110 |
| Content ratio of alumina particles having particle diameter of 25 µm or more and less than 75 µm (% by mass) | 0.02 | 0.01 | <0.01 | 0.1 | 0.01 | 0.02 | 0.11 | 0.02 | 0.01 | 0.03 |
| Content ratio of alumina particles having particle diameter of 1 µm or less (% by mass) | 19 | 16 | 90 | 11 | 9 | 85 | 23 | 0 | 36 | 21 |
| Average sphericity of alumina particles having 50 nm or more and 1 µm or less | 0.82 | 0.92 | 0.93 | 0.92 | 0.93 | 0.91 | 0.91 | - | 0.93 | 0.79 |

| Properties as encapsulant | | | | | | | | | | |
|---|---|---|---|---|---|---|---|---|---|---|
| Formulation | 1 | 1 | 2 | 1 | 1 | 2 | 1 | 1 | 1 | 1 |
| Spiral flow value (cm) | 123 | 145 | 131 | 145 | 165 | 123 | 147 | 103 | 131 | 111 |
| Moldability (burr length, mm) | 2.4 | 2.5 | 1.8 | 2.2 | 2.1 | 1.9 | 2 | 3.6 | 2 | 2 |
| Amount of wire sweep (µm) | 33 | 33 | 22 | 29 | 27 | 27 | 26 | 25 | 25 | 26 |

**[Table 3]**

| | Comparative Example 1 | Comparative Example 2 | Comparative Example 3 | Comparative Example 4 | Comparative Example 5 | Comparative Example 6 |
|---|---|---|---|---|---|---|
| Production conditions | | | | | | |
| Type of alumina raw material | 2 | 4 | Metal Al | 4 | 4 | 1 |
| Oxygen gas supply rate (Nm³/hour) | 25 | 40 | 10 | 35 | 35 | 35 |
| Fuel gas supply rate (Nm³/hour) | 5 | 8 | 2 | 7 | 7 | 7 |
| Ion exchanged water supply rate (L/hour) | 40 | 40 | 40 | 50 | 10 | 120 |

| Evaluations | | | | | | |
|---|---|---|---|---|---|---|
| Average sphericity of alumina particles having 50 nm or more | 0.79 | 0.84 | 0.86 | 0.85 | 0.89 | 0.84 |
| Content ratio of alumina particles having particle diameter of 75 µm or more (% by mass) | 0.03 | 0.06 | 0.03 | 0.03 | 0.04 | 0.03 |
| Average particle diameter of alumina powder (µm) | 4 | 12 | 0.1 | 16 | 14 | 3 |
| Amount of water included in alumina powder (ppm) | 150 | 60 | 470 | 80 | 20 | 510 |
| Content ratio of alumina particles having particle diameter of 25 µm or more and less than 75 µm (% by mass) | 0.06 | 0.12 | 0.04 | 0.05 | 0.03 | 0.04 |
| Content ratio of alumina particles having particle diameter of 1 µm or less (% by mass) | 20 | 19 | 95 | 31 | 24 | 5 |
| Average sphericity of alumina particles having 50 nm or more and 1 µm or less | 0.81 | 0.91 | 0.90 | 0.90 | 0.90 | 0.89 |

| Properties as encapsulant | | | | | | |
|---|---|---|---|---|---|---|
| Formulation | 1 | 1 | 2 | 1 | 1 | 1 |
| Spiral flow value (cm) | 78 | 107 | 76 | 109 | 79 | 106 |
| Moldability (burr length, mm) | 2.3 | 2.2 | 1.9 | 2.4 | 2.3 | 3.2 |
| Amount of wire sweep (µm) | 39 | 41 | 32 | 43 | 34 | 31 |

The present application is based on a Japanese patent application filed on March 31, 2020 (Japanese Patent Application No. 2020-063815), the contents of which are incorporated herein by reference.

### Industrial Applicability

According to the present invention, an alumina powder, and a filler composition and a resin composition including the alumina powder, that can suppress wire sweep and the generation of a burr during encapsulation can be obtained. Therefore, the alumina powder, the filler composition, and the resin composition of the present invention are suitable for an encapsulant and a fingerprint authentication sensor.

## Claims

1. An alumina powder comprising alumina particles, wherein
among the alumina particles, an average sphericity of an alumina particle having a projected area equivalent circle diameter of 50 nm or more as determined by microscopy is 0.80 or more, a content ratio of an alumina particle having a particle diameter of 75 µm or more is 0.05% by mass or less,
an average particle diameter of the alumina powder is 0.2 µm or more and 15 µm or less,
the average particle diameter is a particle diameter measured using a laser light diffraction scattering particle size distribution analyzer, and
an amount of water included in the alumina powder measured by the following measurement method is 30 ppm or more and 500 ppm or less:
(Measurement method)
1 g of the alumina powder is heated to raise a temperature thereof from normal temperature to 900°C, and an amount of water generated at 500°C or more and 900°C or less is measured by the Karl Fischer coulometric titration method.

2. The alumina powder according to claim 1, wherein a content ratio of an alumina particle having a particle diameter of 25 µm or more and less than 75 µm is 0.1% by mass or less.

3. The alumina powder according to claim 1 or 2, wherein a content ratio of an alumina particle having a particle diameter of 1 µm or less is 1% by mass or more and 35% by mass or less, and an average sphericity of an alumina particle having a projected area equivalent circle diameter of 50 nm or more and 1 µm or less as determined by microscopy is 0.80 or more.

4. A filler composition comprising the alumina powder according to any one of claims 1 to 3 and a silica.

5. A resin composition comprising a resin, and the alumina powder according to any one of claims 1 to 3 or the filler composition according to claim 4.

6. An encapsulant comprising the resin composition according to claim 5.

7. A fingerprint authentication sensor comprising the encapsulant according to claim 6.
